Europäisches Patentamt

(19) European Patent Office

Office européen des brevets

(11) **EP 0 957 573 A1**

(12) **EUROPEAN PATENT APPLICATION**

(43) Date of publication:
**17.11.1999 Bulletin 1999/46**

(51) Int. Cl.$^6$: **H03D 9/04**, H04L 27/38

(21) Application number: **98108835.4**

(22) Date of filing: **14.05.1998**

| | |
|---|---|
| (84) Designated Contracting States:<br>**AT BE CH CY DE DK ES FI FR GB GR IE IT LI LU MC NL PT SE**<br>Designated Extension States:<br>**AL LT LV MK RO SI** | (72) Inventors:<br>• Krupezevic, Dragan, Dr.-Ing.<br>**Stuttgarter Strasse 106, 70736 Fellbach (DE)**<br>• Brankovic, Veselin, Dr.-Ing.<br>**Stuttgarter Strasse 106, 70736 Fellbach (DE)** |
| (71) Applicant:<br>**Sony International (Europe) GmbH**<br>**50829 Köln (DE)** | (74) Representative:<br>**Rupp, Christian, Dipl.Phys. et al**<br>**Mitscherlich & Partner**<br>**Patent- und Rechtsanwälte**<br>**Sonnenstrasse 33**<br>**80331 München (DE)** |

(54) **Five-port junction device**

(57) According to the present invention a five-port junction device for processing (down-conversion etc.) of RF-signals is proposed. The device comprises one passive four-port means (1) being connected with a passive three-port means (2) by a phase-shifting element (3). The passive four-port means (1) comprises a port (4) for the input of a first RF-signal and two output ports. The passive three-port means (2) comprises a second port (4) for the input of a second RF-signal and one output port. The output ports respectively provide output signals being linear combinations of the first and the sec-ond RF input signal. Power sensors $P_1$, $P_2$, $P_3$ are provided to detect the respective power levels of the output signals.

Respectively one power sensor can be connected to one of said output ports and a signal processing unit (26) is provided to calculate the complex ratio of the first and second input RF-signals on the basis of the power level values detected and output by the power sensors $P_1$, $P_2$, $P_3$.

Fig. 1

## Description

The present invention relates to a five-port junction device for the processing of RF-signals, and a method for the direct down conversion of RF-signals. The principle of the present invention finds its application for example in the reception of RF signals or the vector measurement of RF signals based on a five-port junction device.

A six-port receiver is known acting in the direct conversion manner and allowing conversion from mm-wave range and microwave range directly to the base band. At the same time a classic I/Q-demodulation chip (digital or analog) can be avoided. By using suitable calibration procedures the influences of the non-ideal passive RF-components including manufacturing tolerances can be minimized. The six-port receiver detects the relative phase and relative magnitude of two incoming RF-signals. The circuitry of the six-port receiver is realized using only passive components in combination with diodes for the detection of the relative phase and the relative magnitude of the RF-signals. An important feature of six-port receivers is that fabrication tolerances can be calibrated, which inherently allows low-cost production.

In Bossisio, Wu "A six-port direct digital millimeter wave receiver", Digest of 1994 IEEE MTT Symposium, vol. 3, page 1659 - 1662, San Diego, May 1994, a structure for a six-port receiver is proposed.

The six-port technique has been known for its ability to accurately measure the scattering parameters, both amplitude and phase, of microwave networks. Instead of using heterodyne receivers a six-port receiver accomplishes direct measurements at microwave and mm-wave frequencies by extracting power levels at at least three and particularly four of the 6 ports. The imperfections of the hardware can be readily eliminated by an appropriate calibration procedure. Very accurate measurements can be made in a large dynamic range and wide frequency range. six-port junction receivers consist of passive microwave components such as directional couplers and power dividers as well as diode detectors. The circuit can be easily integrated as MHMIC or MMIC. The known receiver performs direct phase/amplitude demodulation at microwave and mm-wave frequencies.

By performing a calibration procedure the hardware imperfections such as phase error of the bridges, imbalance of the power detectors, etc. can be readily eliminated. This significantly eases the requirement of the hardware implementation and enables the six-port receiver to operate over a wide band up to mm-wave frequencies.

According to the above cited document of Bossisio et. al. a six-port receiver concept with power dividers and 90 degrees hybrid circuits realized in distributed technology is used. The application of that known structure lies mainly in the frequency bands above 10 GHz, however, it suffers from an insufficient band width of the operation due to the inherently frequency selective nature of the 90 degrees hybrid circuits.

From D. Maurin, Y.Xu, B.Huyart, K.Wu, M. Cuhaci, R. Bossisio "CPW Millimeter-Wave Six-Port Reflectometers using MHMIC and MMIC technologies", European Microwave Conference 1994, pp. 911-915, a wide-band topology for reflectometer used is known which is based on a distributing element approach featuring coplanar wave guide applications in the frequency range from 11 to 25 GHz.

From V. Bilik, et al. "A new extremely wideband lumped six-port reflectometer" European Microwave Conference 1991, pp. 1473-1477 and the idea of using Wheatstone Bridges and resistive structures for reflectometer applications is known.

From j:Li, G.Bossisio, K.Wu, "Dual tone Calibration of Six-Port Junction and its application to the six-port direct digital receiver", IEEE Transactions on Microwave Theory and Techniques, vol. 40, January 1996 a six-port reflectometer topology based on four 3dB hybrid circuits, power dividers and attenuators is known.

From US-A-5498969 an asymmetrical topology for a reflectometer structure featuring matched detectors and one unmatched detector is known.

From US-A-4521728 with the title "Method and six-port network for use in determining complex reflection coefficients of microwave networks" a reflectometer six-port topology is known comprising two different quadrate hybrids, phase shifter, two power dividers and one directional coupler for which the realization by a microstrip line technology is disclosed.

The six-port technology inherently has the disadvantage that the computational effort is large for example in comparison with classic approaches (superheterodyne receivers).

It is the object of the present invention to provide a further development of the known six-port technology such as to reduce the topology requirements and to allow a simpler operation.

Furthermore functionality of a six-port receiver technology should be maintained, however, the RF-circuitry and the requirements for A/D-converters should be reduced.

The central idea of the present invention to achieve the above-stated object resides in the provision of a five-port topology comprising two inputs and three analog outputs, wherein the analog outputs can be used for the calculation of the complex ratio of the two input signals.

According to the present invention therefore a five-port junction device for the processing of RF-signals is provided. The device comprises one passive four-port means being connected with a passive three-port means by a phase-shifting element. The passive four-port means comprises a port for the input of a first RF-signal and two output ports. The passive three-port means comprises a second port for the input of a second RF-signal and one output port.

The output ports respectively supply output signals being linear combinations of the first and the second RF input signal. Furthermore, power sensors are provided to detect the respective power levels of the output signals.

Respectively one power sensor can be connected to one of said output ports and a signal processing unit can be provided to calculate the complex ratio of the first and second input RF-signals on the basis of the power levels detected and output by the power levels detected and output by the power sensors.

The power sensors can comprise respectively at least one diode.

The power sensors can comprise a matching circuitry realized by discrete or distributed elements, a diode memory block storing diode calibration coefficient, a biasing means and/or a processing unit for correcting temperature and non-linear detection errors.

The passive four-port means and the passive three-port means can respectively comprise a resistive network.

The resistive network thereby can comprise a microstrip ring or a circular microstrip patch. The phase-shifting element can be a single transmission line, e.g. a microstrip line.

The phase-shifting element can comprise a plurality of coplanar transmission lines.

The phase-shifting element can comprise a coplanar wave guide.

The phase-shifting element can comprise a LC-circuit or a PI-circuitry built up from a plurality of capacitors and an inductivity.

The phase-shifting element can comprise a T-LC-circuitry.

The passive four-port means can comprise a passive power divider and a second passive three-port means. The passive power divider thereby can be connected with said input port for a RF-signal, with a power sensor as well as with the second passive three-port means. The second passive three-port means furthermore can be connected with another power sensor and with a three-port means by means of said phase shifting element.

The passive power divider can comprise at least three resistive elements.

The power divider can be realized by distributor technology.

The power divider can be realized by a microstrip ring or a circular microstrip patch.

The passive three-port means can be realized by a distributor technology.

The passive three-port means can comprise a microstrip line, coplanar strips or a coplanar wave guide.

One of the input RF-signals can be provided by a local oscillator circuitry.

The five-port junction device can be realized by MMIC (monolythic microwave integrated circuit)-technology.

Alternatively this can be realized by hybrid technology.

The five-port junction device can be used for the direct down-conversion of an RF-signal.

Particularly, it can be used for the down-conversion of a QPSK-, QAM- or OFDM-modulated RF-signal.

According to the present invention furthermore a method for the direct down-conversion of RF-signals is provided. Thereby, two RF-signals are input to a five-port receiver. Three output signals being based on linear combinations of said two RF-input signals are output from the five-port receiver. The power levels of the three output signals are detected and the complex ratio of the two input RF-signals is calculated on the basis of the three output signals.

The five-port receiver can be calibrated by feeding a predetermined calibration sequence to an input of the five-port receiver and calculating calibration coefficients.

Therefore, according to the present invention a five-port technology comprising only three power sensors is provided.

Fig. 1 shows the general concept of the present invention,

Fig. 2 shows an embodiment of the general structures shown in Fig. 1, wherein resistive networks are provided,

Fig. 3 shows an embodiment of the present invention, wherein a four-port means and a three-port means are realized as microstrip rings and the phase shifter is realized as a transmission line,

Fig. 4 shows an embodiment of the present invention, wherein the four-port means and the three-port means are realized as circular microstrip patches,

Fig. 5 shows an embodiment of the present invention, wherein the four-port means are build up respectively from a second passive three-port means and a passive power divider,

Fig. 6 shows a possible realization of the four-port means by a resistive network,

Fig. 7 shows another possible realization of the embodiment of Fig. 2 by resistive networks,

EP 0 957 573 A1

Fig. 8A and 8B show possible realizations of the power divider and the second three-port means by resistive networks,

Fig. 9 shows a possible realization of a three-port means by a resistive network,

Fig. 10A to 10B show power dividers realized by distributed technology with microstrip rings and microstrip patches, respectively,

Fig. 10C shows a realization of the three-port means of Fig. 5 with distributed technology,

Fig. 11 shows realizations of a four-port structure and a three-port structure using coplanar waveguide technology,

Fig. 12A to 12C show different realization forms of the phase shifting element according to different embodiments, the phase shifting element being implemented by discrete technology,

Fig. 13 shows the internal structure of a power sensor according to an embodiment,

Fig. 14A to 14C show different realizations of the phase shifting element in distributed technology,

Fig. 15 shows the internal structure of a local oscillator circuitry according to an embodiment,

Fig. 16 and 17 show further developments of the embodiment of the invention shown in figure 5, and

Fig. 18 to Fig. 21 show simulation results achieved when using the technology according to the present invention.

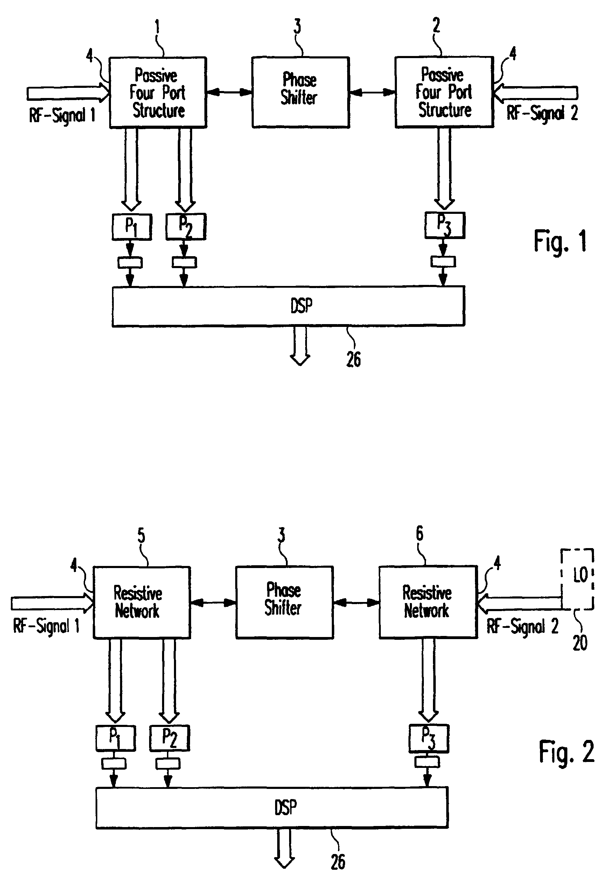

According to the present invention a new topology for a five-port circuitry usable preferably, but not only, for receivers is proposed. The basic concept of the proposed five-port topology is shown in Fig. 1. As shown in Fig. 1 the basic structure of the present invention comprises one passive four-port means 1 and a passive three-port means 2 connected with each other by a phase-shifter 3. Respectively one RF-signal is input (reference 4) to the passive four-port means 1 and the passive three-port means 2. The passive four-port means 1 comprises two output ports which are connected to power sensors $P_1$ and $P_2$. The passive three-port means 2 comprises only one output port being connected with a power sensor $P_3$. When the topology according to the present invention is used as a receiver, all of the power sensors (usually comprising detector diodes) are matched e.g. on an impedance of 50 Ohms.

The passive four-port means 1 and the passive three-port means 2 output respectively signals which are representing linear combinations of the input (and eventually phase-shifted) RF-signals, as it is known e.g. from the technical field of six-port receivers. The power sensors $P_1$ to $P_3$ detect a power level of the output signals of the passive four-port means 1 and the passive three-port means 2. The detected power levels of the power signals are supplied to a digital signal processing unit 26.

Usually plural circuit elements are connected between each power sensor $P_1$ to $P_3$ and the DSP 26, which, however, are not shown in the drawings. These circuit elements can comprise e.g. a low-pass filter, a DC-amplifier and an AD-converter in this order.

It is to be noted that the DSP 26 can be avoided when simple modulation techniques are used. In this case, analog circuit elements can be provided acting as a decision circuitry to detect the modulation states of the input RF-signals.

The digital signal processing unit 26 calculates the complex ratio of the two input RF-signals by means of a mathematical treatment of the power level value detected by the power sensors $P_1$ to $P_4$ and can furthermore optionally provide for a demodulation. To summarize, according to the basic concept of the present invention, one of the ports of the passive four-port means 1 is used to input an RF-signal, one is used to be connected to a phase shifter 3 being connected with the passive three-port means 2, and the other two ports of the passive four-port means 1 are used to output signals to power sensors $P_1$, $P_2$.

The passive three-port means 2 comprises one port for the input of a second RF-signal, one port for the connection with the phase shifter 3 and one port for the output of a signal to the power sensor $P_3$.

In order to increase the frequency range of operation, the passive four-port means 1 and the passive three-port means 2 can be realized by resistive networks using discrete elements 5, 6 as it is shown in the embodiment according to Fig. 2. As it is furthermore shown in Fig. 2 and explained in detail further below, one of the RF-signals input to the passive four-port means 1 or to the passive three-port means 2 can be provided by a local oscillator circuitry 20.

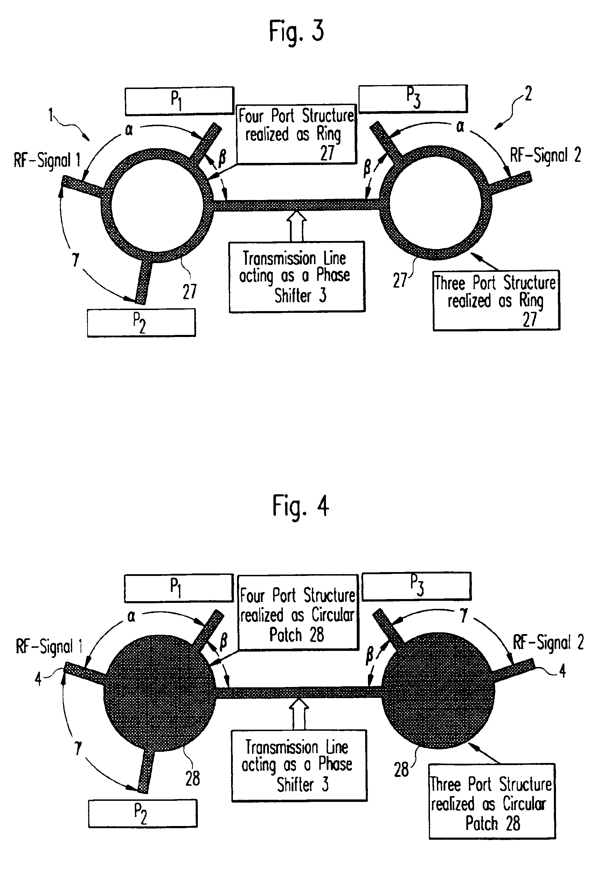

As it is shown in Fig. 3 and 4, the four-port means 1 and the three-port means 2 can be realized by using distributor technology. The two examples of Fig. 3 and 4 show possible topologies. In both examples a transmission line, e.g. a microstrip line, is used as phase shifting element 3. The passive four-port means 1 can be realized as shown in Fig. 3 as a microstrip ring 27 or as a circular microstrip patch 28 as shown in Fig. 4. The same is true for the passive three-port means 2.

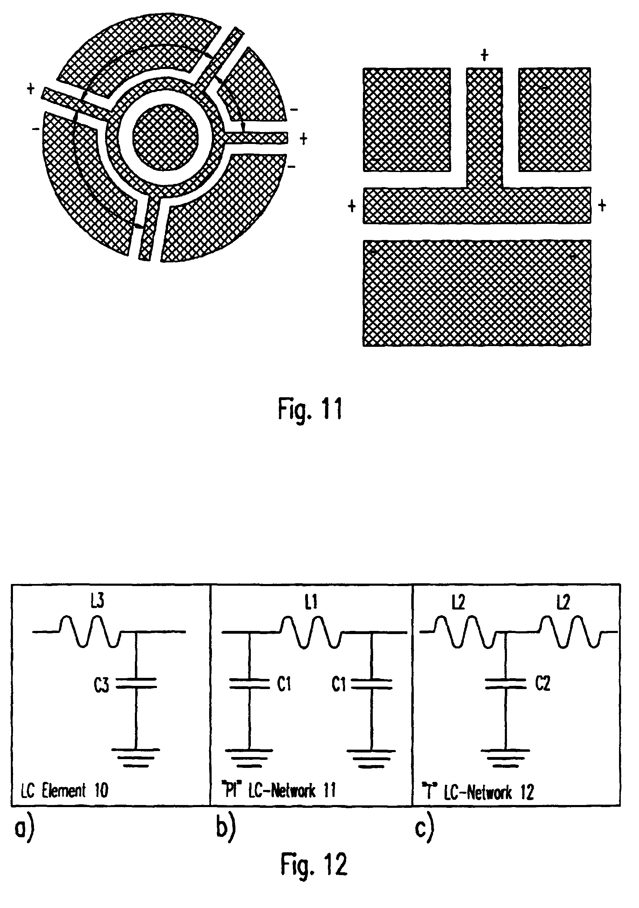

In both cases the diameter (also the inside diameter in the case of Fig. 3) is selected depending on the center frequency of the application. Furthermore it is to be noted that the strip width along the ring can vary. The angles $\alpha$, $\beta$ and $\gamma$ between respectively two ports are chosen such as to establish the wanted combining ratio of the input RF-signal directly attached to one port of the three-port means or to the four-port means, respectively, and a signal coming via the transmission line acting as a phase-shifting element 3. In other words, the angles are set depending on the linear combination of the input RF-signals. For special applications it is also possible to set the values of the angles $\alpha$, $\beta$ and $\gamma$ such as to establish the state that the power sensor $P_2$ (e.g.) detects only the RF-signal 1 meaning that the power sensor $P_2$ and the phase-shifting element 3 connected therewith are isolated. At the same time, the power sensor $P_1$ can receive and detect the power level as a combined value of the RF-signal and the RF-signal 2 approaching the port of the power sensor $P_1$ via the phase-shifting element 3. It is to be noted that the phase-shifting element 3 can be realized in distributor technology, e.g. by a plurality of transmission lines as will be explained with reference to Fig. 11 further below.

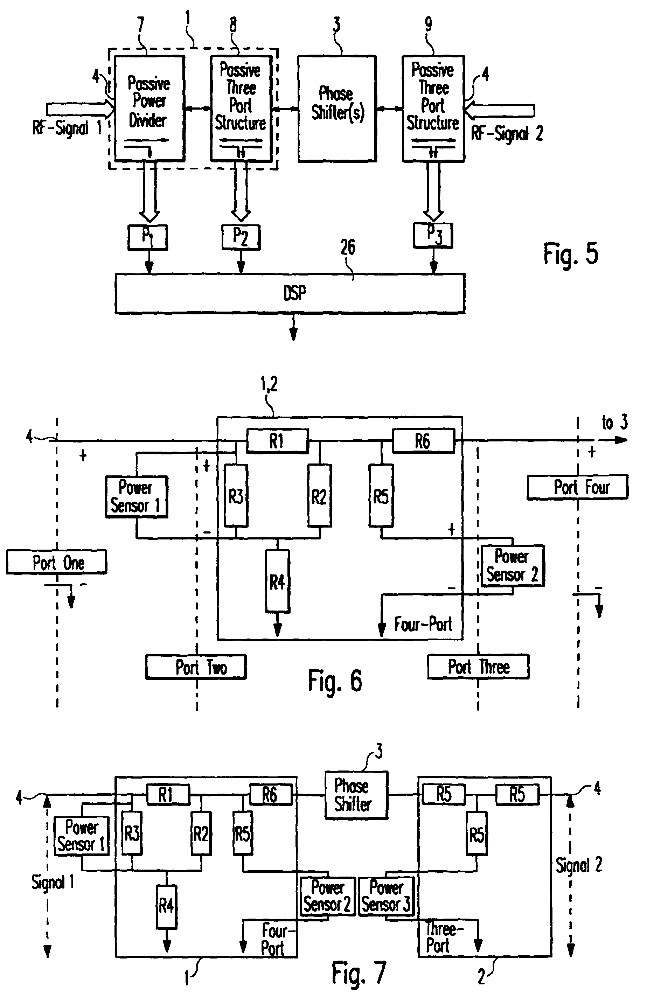

Fig. 5 shows an embodiment of the present invention, wherein the four-port means 1 comprises a passive power divider 7 and a second passive three-port means 8. The passive power divider 7 essentially has the structure of a three-port means. The second passive three-port means 8 acts as a signal combining means. The power divider 7 has the function to split the power of an input RF-signal in two directions:

a) Towards the input of the second three-port means 8 acting as a power combiner, and

b) towards the input of the power sensor $P_1$.

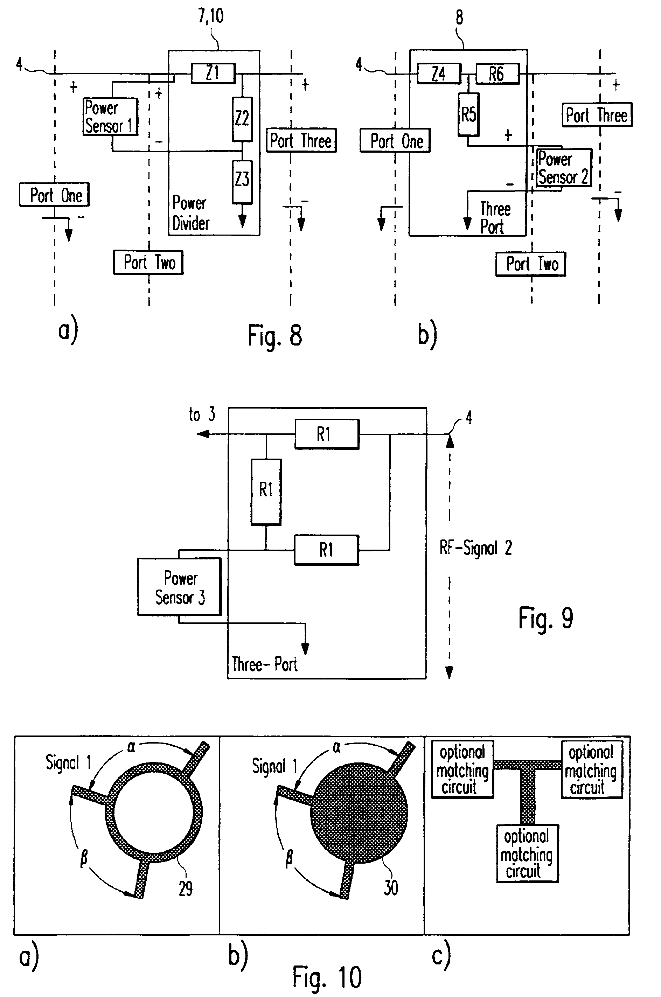

The port attached to the power sensor is isolated from the port attached to the three-port means, meaning that only the RF-signal coming from the second three-port means 8 approaches the power sensor $P_1$. This specific realization is achieved when the resistive elements of Fig. 8 satisfy the equation: $Z1 * Z2 = (Z2)^2$.

The passive three-port means 8, 9 combine the signals coming from the passive power divider 7 and the RF-signals coming from the phase shifter 3, so that combined signals can be detected at the power sensors $P_2$ and $P_3$.

Fig. 6 shows a possible realization of the four-port means 1 according to Fig. 1 by resistive elements. The whole four-port means 1 is realized by at least four resistive elements R1 to R6 which are connected as shown in Fig. 6. In the embodiment of Fig. 6 the elements are chosen such that the power sensor $P_1$ only detects the RF-signal coming from port 1 (reference 4), meaning that port 2 and port 4 of Fig. 6 are preferably isolated. Port three as shown is finished by the power sensor $P_2$ which detects the combined RF-signals coming from port 1 and port 4. In the following table 1, possible preferable values for the resistors of Fig. 6 are given for three different cases normalized to input characteristic impedance to be seen from port one towards outside (usually 50 Ohms or 75 Ohms). It is to be noted that the case is considered that the power sensors have all the same input impedance (matched).

Furthermore, it is to be noted that the power sensor $P_1$ is connected in parallel to the resistor R3 and the power sensor $P_2$ is connected in series between the resistor F5 and ground, which is a preferable implementation.

In some cases the resistors R4 and R5 can be neglected. However, the resistors R1, R2 and R3 connected in a triangular way are important.

Table 1

|  | Z1 | Z2 | Z3 | Z4 | R5 | R6 | R1 | R2 | R3 | R4 |
|---|---|---|---|---|---|---|---|---|---|---|
| Case 1 | ¾ | 1 | 4/3 | 1/3 | 1/3 | 1/3 | 4/3 | 16/9 | 4 | 4/3 |
| Case 2 | 1/2 | 1 | 2 | 1/3 | 1/3 | 1/3 | 1 | 2 | 3 | 2 |
| Case 3 | 1 | 4/$\sqrt{5}$ | 4/$\sqrt{5}$ | 1/3 | 1/3 | 1/3 | ($\sqrt{5}$+1)/3 | 4/3(1+1/$\sqrt{5}$) | ($\sqrt{5}$+1) | 4/$\sqrt{5}$ |

The shown values of the restive elements are particularly advantageous for practical realizations.

In the above table 1 three sets of the values for the resistive elements are proposed taking into account the structures as shown in Fig. 6, 7 and 8. Cases 1 and 2 are leading to the resistive values easy to be realized taking into account the fact that normalization impedance is usually 50 Ohms (sometimes 75 Ohms). These values ensure theoretically the ideal realization of the proposed topology in the case of an ideal input impedance (ideal matching or ideal in search loss) of the power sensors and circuitry providing the RF-signal 1 and the RF-signal 2 in Fig. 1. Taking into account the ideal matching conditions of the power sensors $P_1$ to $P_4$ and the attached circuitry it follows:

Case 1 obtained when the maximum power level which can be detected on the power sensor $P_2$ of Fig. 6 or Fig. 7 is equal to the power level obtained at the power sensor $P_1$ on the same figures, when both RF-signals have the same power level. This will incorporate automatic treatment of the non-linearity case, when the RF-signal approach some predefined border.

Case 2 is evaluated as an ideal case where the signal magnitude approaching power sensor one is the same as average signal magnitude approaching the power sensor two in the case of arbitrary phase shift between the signal one and signal two of the Fig. 1, when they have the same input power level. The case 2 gives very simple easy to be realized and combined resistive ratios. For example if a characteristic impedance is 50 Ohms, the whole passive structure can be realized by resistors taking values of: 50 Ohms, 100 Ohms, 50/3 Ohms, which can be also realized by putting 50 Ohm resistors in parallel or serial connections.

Case 3 is obtained considering the fact that middle power to be achieved at the power sensor two is the same as a power detected at the power sensor one, when signals one and two of the Fig. 1 have the same power level and different phases. This approach leads to resistor values not having "the simple" to be realized resistive values, but they make an optimum power leveling.

Fig. 7 shows a five-port junction device (five-port receiver) comprising a four-port means and a three-port means.

Fig. 8A and 8B show a realization of the power divider 7, 10 and the passive three-port means 8, 9 of Fig. 5 by resistive elements. As can be seen from Fig. 8A and 8B the passive power divider 7, 10 can be realized by at least 3 resistive elements $Z_1$, $Z_2$ and $Z_3$. The same is true for the passive three-port means 8 realized by resistive elements $Z_4$, $R_5$ and $R_6$. The possible values (three different cases to be explained later) for the resistive elements are given in the above table 1 normalized to the characteristic impedance of the system (usually 50 Ohms or 75 Ohms). The power sensors $P_1$ to $P_4$ are connected as shown in Fig. 8A and 8B.

Thereby it is to be noted that the power sensor $P_1$ is connected in parallel to the resistors Z1 and Z2 and the power sensor $P_2$ is connected in series between the resistor R5 and ground.

Fig. 9 shows a possible realization of the three-port structure of Fig. 5 regarding the first passive three-port means 2 at the right side of the phase shifter 3.

In Fig. 10A to 10C possible distributed element realizations in microstrip technology are shown. Fig. 10A thereby shows the realization of passive power dividers 7 with a microstrip ring 25. Fig. 10B shows the realization of the passive power divider 7 with a microstrip edge 30 and Fig. 10C shows the realization of the passive three-port means 8, 9 by a microstrip technology with an optional matching circuit.

The angles $\alpha$ and $\beta$ of the microstrip ring and the microstrip circular patch are chosen in a way to ensure an isolation of the ports attached to the power sensor $P_1$ and the passive three-port means 8, 9. It is to be noted that the diameter and the angles of the rings and the patches are chosen depending on the specific frequency of interest, and furthermore the strip width along the ring can vary. Also in the microstrip realization of Fig. 10C of the three-port means different strip widths can be used.

Fig. 11 shows a realization of the proposed distributor technology as a coplanar waveguide technology instead of microstrip line technology applied on a passive three port means.

If a resistive, mainly discrete approach is used for the four-port means (or the power divider in the three-port means), there are two options to realize the phase shifting element 3:

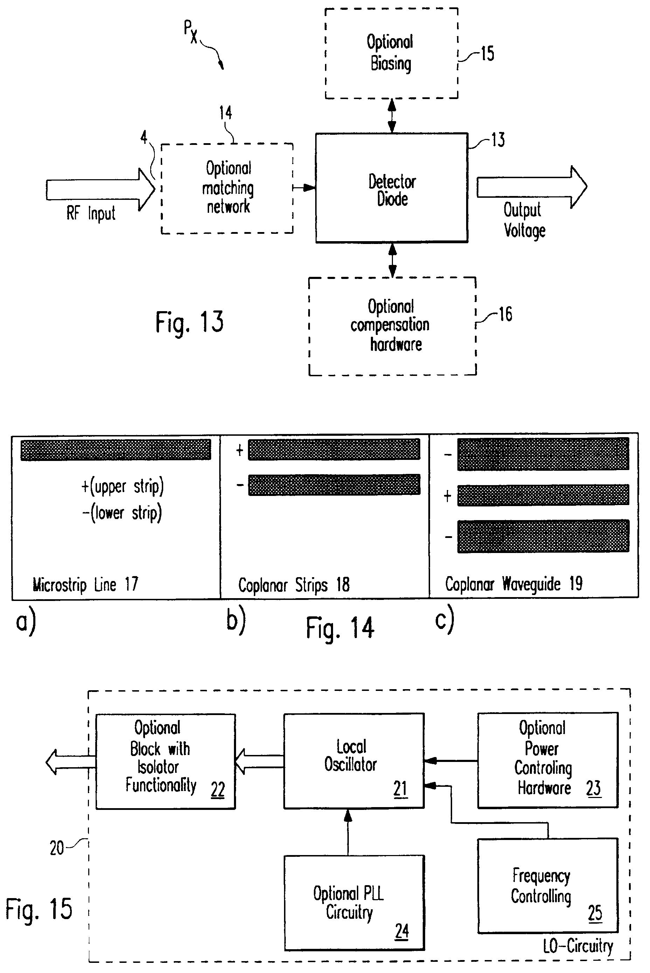

a) Using a distributed technology as shown in Fig. 14, where the phase shifting element 3 is realized by transmission lines 17, 18, which do not have to be straight (they can also be made in a curve-like shape in order to minimize the length of the line) and
b) by using discrete LC-elements as shown in Fig. 12.

In Fig. 12A to 12C three different cases are shown. As shown in Fig. 12A the phase shifting element can be realized by at least one inductivity $L_3$ and one capacitor $C_3$ making up one LC-cell 10.

As shown in Fig. 12B the phase shifting element can be realized by a "PI" LC-network 11 comprising two capacitors $C_1$ and one inductivity $L_1$. As shown in Fig. 12C the phase shifting element can be realized by a T-LC-network 12

comprising two inductivities $L_1$, $L_2$ and one capacitor $C_2$ connected in a T-shape.

In Fig. 13 the internal structure of a power sensor $P_x$ ($0 < x < 4$; x being an integer) is shown. A power sensor $P_x$ essentially comprises at least one detector diode 13, an optional matching network 14, an optional biasing element 15, and an optional compensation hardware 16 providing for a temperature compensation of the diode characteristic. The optional matching network 14 is preferably realized by frequency independent elements (preferably using resistive elements) and is responsible to transform the power sensor input impedance to the same value as the characteristic impedance of the system (usually 50 Ohms or 75 Ohms). The biasing elements 15 give the possibility to increase the sensitivity of the detector diode 13 when applied according to the technology of the used diode process, and external system requirements. The optional compensation hardware 16 can automatically modify the information of the detected power (usually D/C-voltage) in order to minimize the temperature influences or diode non-linearity if a detected signal exceeds a previously assigned voltage border. Of course this function can also be achieved by software corrections for using the measured power values for the calculation of the complex ratio of the two input RF-signals in the digital signal processing unit 26.

Fig. 14a to 14c show possible realizations of the phase shifting element in distributed technology. According to Fig. 14A the phase shifting element can be realized by a microstrip line 17. As shown in Fig. 14B the phase shifting element can be realized by coplanar strips 18. As shown in Fig. 14C the phase shifting element 3 alternatively can be realized as a coplanar wave guide 19.

If the five-port junction device according to the present invention is to be used as a five-port direct receiver usually one of the ports where the RF-signals are fed into the circuitry (see Fig. 1) is fed by a local oscillator (LO) circuitry as reference with 20 in Fig. 15. The LO-circuitry 20 comprises a local oscillator 21 and optionally a power controlling hardware block 23, a PLL block 24, a frequency controlling block 25 and a block 22 having an isolator function as shown in Fig. 15.

It is to be noted that the main difference between a five-port direct receiver and the classic six-port direct receiver topology is that five-port topology does not need to measure (online) the power level of the local oscillator 21. Using this approach, a significant simplicity of the topology can be achieved on the RF side (less resistors or less RF-circuitry) and on the base band side (one A/D converter less with associated amplifiers and low-pass filters suppressed). The necessary information about the input LO power level is obtained by a calibration process, which can be done offline (in viewing device manufacturing and integration phase) or online. This has the advantage particularly if the power of the lock and oscillator 21 is not changed. In any case a calibration procedure is preferable for all local oscillator power levels when using the present invention.

The proposed topology is adopted to the usage as a direct five-port receiver. It is especially described and proposed to be applied as a solution for wide-band frequency applications. If a discrete solution technique with the proposed technology is utilized, a wide-band frequency solution is possible also for a lower frequency range under 10 GHz. The proposed topology minimizes the required surface in both the discrete and the distributed solution, and furthermore it can be realized by a simple resistor topology. The proposed five-port topology requires less circuitry in comparison to the classic six-port topology, but can need a calibration in order to reduce the influence of the information about the LO power level. The topology according to the present invention is particularly interesting in the case that the power level of the local oscillator 21 does not change or has a preprogrammed fixed value, which means in the case that the input RF signal is influenced by AGC or a programmable step attenuator before approaching the input port of a five-port junction structure according to the present invention.

In the following a method for calibrating a five-port junction device is explained.

The calibration procedure can be done in two steps. One cycle of the calibration procedure should be done for each of the intended LO power levels and for specified major frequencies of interest.

First step

At the input (RF signal 1 in fig. 1 for example) of the five-port junction device a predefined signal sequence is fed. This predefined calibration signal is preferably ISK-modulated with at least five different phase dates, and is followed by a signal with different power levels and arbitrary phase. The power level of the local oscillator (which is needed for the calculation of calibration coefficients) is approximately known. As a result of the calibration procedure, the calibration coefficients are calculated for overcoming non-ideal RF-circuitry.

Second step

Additionally two signals (an RF-signal with at least two different phases) are fed to the circuit. After applying the calibration coefficients in the previous step, two additional calibration coefficients (complex numbers) are calculated, which compensate for the assumed value for the input LO magnitude and phase to the actual value on the particular device. The equation for the calculation of additional calibration coefficients can be expresses as follows:

$$\text{correct value} = \text{detected value (with standard calibration coefficients)} \times$$
$$\text{AA (complex number)} + \text{BB (complex number)}$$

This can be mathematically expressed as a complex linear transformation.

It is to be noted that this additional calibration can also be used for dealing with the compensation of the phase shifter (see Fig. 1) values. This is the case, when the phase shifter shifts the signal with a frequency dependent phase shift and when the calibration of the circuits is done only at one frequency.

It is to be noted that, if the LO power changes during the operation of the device, the calibration procedure (step 2) should be repeated and the related complex coefficients for the linear transformation should be memorized.

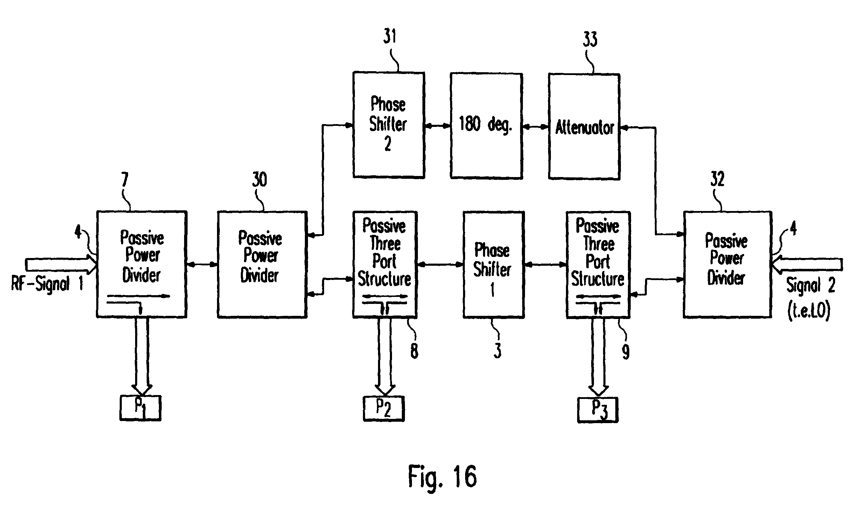

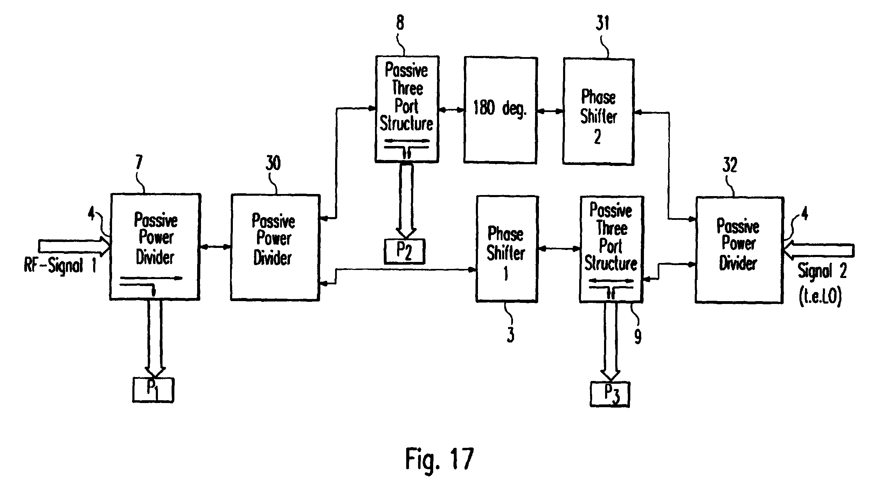

With reference to Figures 16 and 17 further developments of the embodiment as shown in Fig. 5 will now be explained.

As can be seen from Fig. 16, according to this embodiment a further passive power divider 30 is connected between the first passive power divider 7 and the passive three-port structure 8. The passive power divider 30 is connected by means of a second phase shifter 31 and an attenuator 33 with a power divider 32. The second phase shifter 31 can provide for a phase shift of 180 degrees. In comparison to the embodiment according to Fig. 5 therefore two passive power dividers 30, 32, a phase shifter 31 and the attenuator 33 have been added. The first phase shifter 3 can also provide for a phase shift of 180 degrees.

Fig. 17 shows another embodiment according to which the passive three-port structure 8 is interconnected between the passive power divider 30 and the phase shifter 31. In this case the attenuator 33 can be omitted.

The embodiments according to Figures 16 and 17 provide for an isolation of the RF-signal port and the local oscillator port.

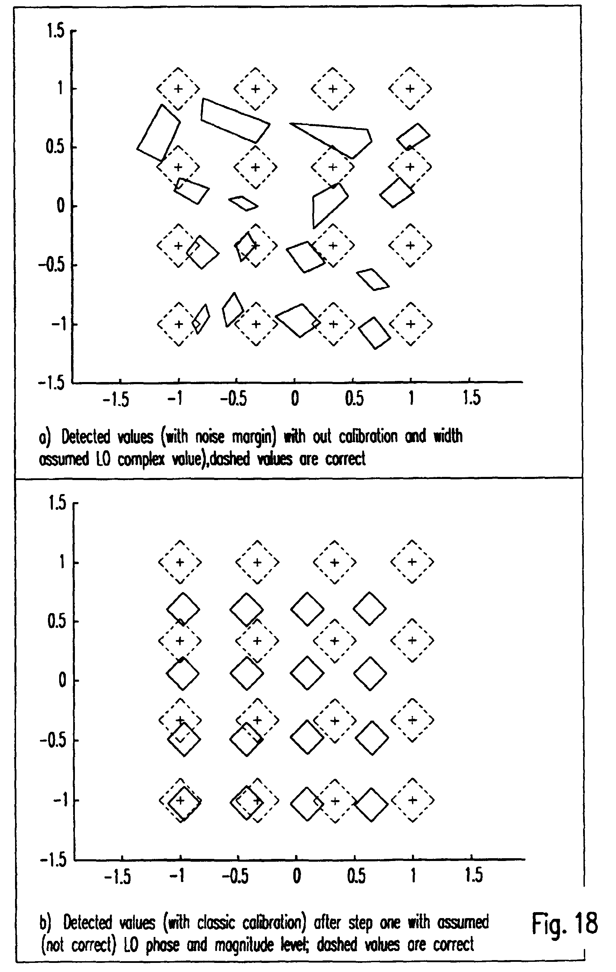

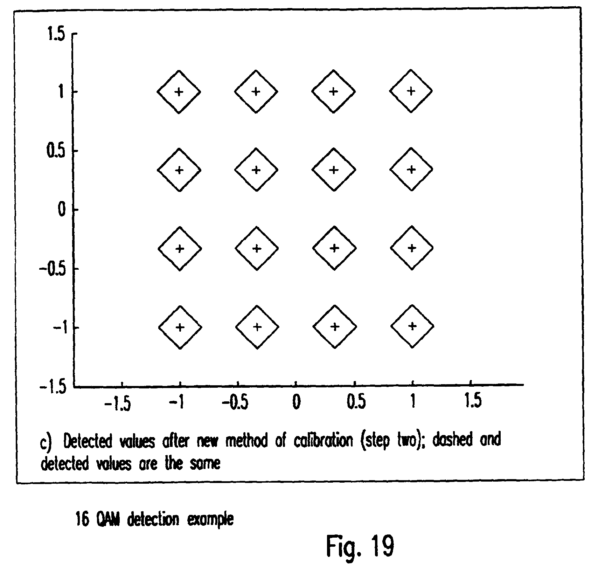

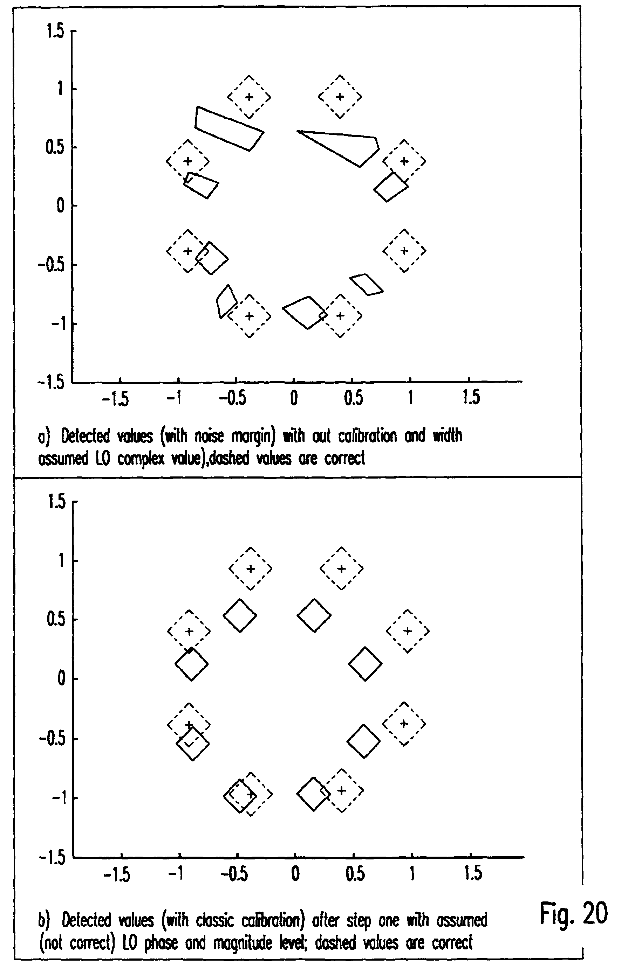

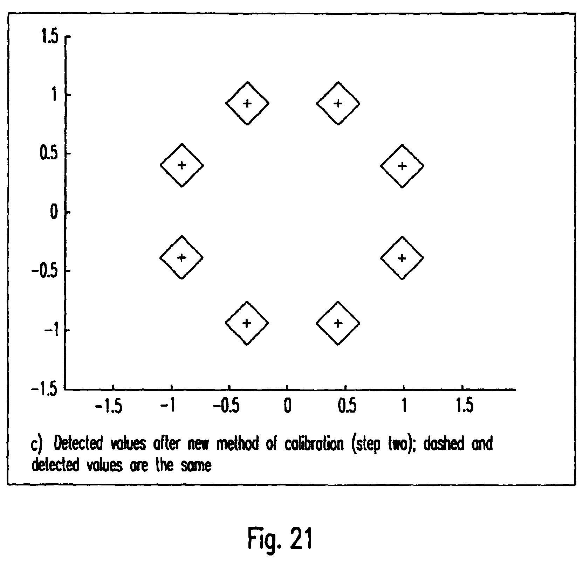

Fig. 18 to 21 show simulation results when using the proposed concept according to the present invention.

In order to verify the concept of the present invention the resistive element discrete topology solution as described in Fig. 15 has been analyzed taking into account case 2 for the values of the resistors as shown in table 1. The simulation environment considered that the resistors had been manufactured with uniformly distributed tolerance, with the effect that the resistor values can vary about 10 %. The phase shifter with electrical length of 45 degrees has been considered. All of the presented results have been obtained by mathematical simulations taking into account the following issues:

- The power sensors are detector diodes which are working in a linear area, having an input impedance with the same tolerances as a discrete resistor of the assembly,

- RF-Signal 2 of Fig. 1 is considered to be a local oscillator signal,

- the LO power has a magnitude which differs by ten percent from the assumed value, and the phase of the LO can differ by 20 degrees,

- the shown blocks having four corners usually present a margin of noise (15 dB compared to the average power),

- the ideal calibration procedure based on five loads approach a six-port to four-port reduction theory has been utilized, wherein the five loads have the same magnitude, and

- 16 QAM and 8 PSK demodulation has been considered.

## Claims

1. Five-port junction device for the processing of RF signals,

   the device comprising one passive four port means (1) being connected with a passive three port means (2) by a phase shifting element (3),
   the passive four port means (1) comprising a port (4) for the input of a first RF signal and two output ports,
   the passive three port means (2) comprising a second port (4) for the input of a second RF signal and one output port,
   the output ports respectively providing output signals being linear combinations of the first and second RF input signal,
   wherein power sensors ($P_1$, $P_2$; $P_3$) are provided to detect the respective power levels of the output signals.

2. Five-port junction device according to claim ,
   characterized in that

   respectively a power sensor ($P_1$, $P_2$; $P_3$) is connected to one of said output ports and a signal processing unit (26) is provided to calculate the complex ratio of the first and second input RF signals on the basis of the power level values detected and output by the power sensors ($P_1$, $P_2$; $P_3$).

3. Five-port junction device according to claim 2,

characterized in that

the power sensors ($P_1$, $P_2$; $P_3$) comprise respectively at least one diode (13).

4. Five-port junction device according to claim 2 or 3,
characterized in that

the power sensors ($P_1$, $P_2$; $P_3$) comprise

- a matching circuitry (14) realized by discrete or distributed elements,
- a diode memory block (16) storing diode calibration coefficients,
- a biasing means (15) and/or
- a processing unit (16) for correcting temperature and nonlinear detection errors.

5. Five-port junction device according to anyone of the preceding claims,
characterized in that

the passive four port means (1) and the passive three port means (2) respectively comprise a resistive network (5, 6).

6. Five-port junction device according to claim 5,
characterized in that

the resistive network (5, 6) comprises a microstrip ring (27).

7. Five-port junction device according to claim 5,
characterized in that

the resistive network (5, 6) comprises a circular microstrip patch (28).

8. Five-port junction device according to anyone of the preceding claims,
characterized in that

the phase shifting element (3) is a single transmission line (17).

9. Five-port junction device according to claim 8,
characterized in that

the transmission line is a microstrip line (17).

10. Five-port junction device according to anyone of claims 1 to 7,
characterized in that

the phase shifting element comprises a plurality of coplanar transmission lines (18).

11. Five-port junction device according to anyone of claims 1 to 7,
characterized in that

the phase shifting element comprises a coplanar waveguide (19).

12. Five-port junction device according to anyone of the preceding claims,
characterized in that

the phase shifting element (3) comprises a LC circuit (10).

13. Five-port junction device according to anyone of the preceding claims,
characterized in that

the phase shifting element (3) comprises a PI circuitry (11) build up from a plurality of capacitors (C1) and an inductivity (L1).

14. Five-port junction device according to claim 13, characterized in that

the phase shifting element (3) comprises two parallel capacitors being connected by means of an inductivity respectively at one end and being connected to ground respectively at their other end.

15. Five-port junction device according to anyone of claims 1 to 11, characterized in that

the phase shifting element (3) comprises a T-LC circuitry (12).

16. Five-port junction device according to claim 15, characterized in that

the phase shifting element (3) comprises two serial inductivities, a capacitor being connected between the midpoint of the inductivities and ground.

17. Five-port junction device according to anyone of the preceding claims, characterized in that

the passive four port means (1) comprises

- a passive power divider (7), and
- a second passive three port means (8),

the passive power divider (7) being connected with said input port (4) for a RF signal, with a power sensor ($P_1$, $P_2$; $P_3$) and with the second passive three port means (8), the second passive three port means (8) furthermore being connected with another power sensor ($P_1$, $P_2$; $P_3$) and with the three-port means (2) by means of said phase shifting element (3).

18. Five-port junction device according to claim 15, characterized in that

the passive power divider (7) comprises at least three resistive elements.

19. Five-port junction device according to claims 15 or 16, characterized in that

the power divider (7) is realized by a distributed technology.

20. Five-port junction device according to claim 18, characterized in that

the power divider (7) is realized by a microstrip ring (29) or a circular microstrip patch (30).

21. Five-port junction device according to anyone of claims 16 to 20, characterized in that

the passive three port means (2, 8) are realized by a distributed technology.

22. Five-port junction device according to claim 21, characterized in that

the passive three port means (2, 8) comprises a microstrip line, coplanar strips or a coplanar waveguide.

**23.** Five-port junction device according to anyone of the preceding claims,
characterized in that

one of the input RF signals is provided by a local oscillator circuitry (20).

**24.** Five-port junction device according to anyone of the preceding claims,
characterized in that

it is realized by MMIC (Monolithic Microwave Integrated Circuit)-Technology.

**25.** Five-port junction device according to anyone of the preceding claims,
characterized in that

it is realized by hybrid technology.

**26.** Use of a five-port junction device according to anyone of the preceding claims for the direct down conversion of a
RF signal.

**27.** Use of a five-port junction device according to anyone of claims 1 to 25 for the direct down conversion of a QPSK-
, QAM- or OFDM-modulated RF signal.

**28.** Method for the direct down conversion of RF signals,
comprising the following steps:

- inputting two RF signals to a five-port receiver,
- outputting three output signals being based on linear combinations of said two RF input signals, and
- detecting ($P_1$, $P_2$; $P_3$) the power levels of the three output signals.

**29.** Method for the calibration of a five-port junction device according to anyone of claims 1 to 27,
characterized in that

at an input (4) of the five-port junction device a predefined modulated RF calibration signal is fed,
which contains at least two different states.

**30.** Method according to claim 29,
characterized in that

the two different states are two different phase states.

**31.** Method according to claim 29 or 30,
characterized in that

a complex linear transformation is effected to calculate correct modulation state values on the basis of actually
detected values,
wherein the coefficients of the complex linear transformation are calculated by comparing the predefined modulation states of the calibration signal with the actually detected values when the calibration signal is fed in at
an input (4) of the five-port junction device.

**32.** Method according to anyone of claims 28 to 31,
characterized in that

it is preceded by another calibration, wherein a modulated RF signal with at least five different phase states is
fed in at an input (4) of the five-port junction device.

1

4

Passive
Four Port
Structure

→ RF-Signal 1

3

Phase
Shifter

2

4

Passive
Four Port
Structure

RF-Signal 2 ←

$P_1$    $P_2$    $P_3$

DSP

26

Fig. 1

5

4

Resistive
Network

→ RF-Signal 1

3

Phase
Shifter

6

4

Resistive
Network

RF-Signal 2 ←

LO

20

$P_1$    $P_2$    $P_3$

DSP

26

Fig. 2

12

## Fig. 3

P<sub>1</sub>

Four Port Structure
realized as Ring
27

P<sub>3</sub>

1

RF-Signal 1

α

β

2

RF-Signal 2

Transmission Line
acting as a Phase
Shifter 3

γ

27

P<sub>2</sub>

α

β

27

Three Port Structure
realized as Ring
27

## Fig. 4

P<sub>1</sub>

Four Port Structure
realized as Circular
Patch 28

P<sub>3</sub>

RF-Signal 1

α

β

γ

RF-Signal 2

4

Transmission Line
acting as a Phase
Shifter 3

γ

28

P<sub>2</sub>

β

28

Three Port Structure
realized as Circular
Patch 28

4

13

Fig. 5

Fig. 6

Fig. 7

7,10

4

+

| Z1 |

Power
Sensor 1

+

−

+

Port Three

Port One

−

| Z2 |

| Z3 |

Power
Divider

−

Port Two

a)

Fig. 8

8

4

| Z4 | R6 |

R5

+

Port One

Port Three

Power
Sensor 2

−

Three
Port

−

Port Two

b)

to 3

4

| R1 |

| R1 |

| R1 |

Power
Sensor 3

RF-Signal 2

Three-Port

Fig. 9

Signal 1    α

β         29

Signal 1    α

β         30

| optional matching circuit | optional matching circuit |

| optional matching circuit |

a)                    b)          c)

Fig. 10

Fig. 11

| | | |
|---|---|---|
| L3 | L1 | L2    L2 |
| C3 | C1    C1 | C2 |
| LC Element 10 | "PI" LC-Network 11 | "T" LC-Network 12 |
| a) | b) | c) |

Fig. 12

16

P$_X$

Optional
Biasing — 15

4      14

RF Input → Optional
matching
network → Detector
Diode — 13 → Output
Voltage

Optional
compensation
hardware — 16

Fig. 13

+(upper strip)
-(lower strip)

Microstrip Line 17

a)

+

-

Coplanar Strips 18

b)     Fig. 14

-

+

-

Coplanar Waveguide 19

c)

← Optional
Block with
Isolator
Functionality  22 ← Local
Oscillator  21 ← Optional
Power
Controling
Hardware  23

20

Fig. 15

Optional PLL
Circuitry  24

Frequency
Controlling  25

LO-Circuitry

Fig. 16

Fig. 17

a) Detected values (with noise margin) with out calibration and width assumed LO complex value),dashed values are correct

b) Detected values (with classic calibration) after step one with assumed (not correct) LO phase and magnitude level; dashed values are correct

Fig. 18

c) Detected values after new method of calibration (step two); dashed and detected values are the same

16 QAM detection example

Fig. 19

a) Detected values (with noise margin) with out calibration and width assumed LO complex value),dashed values are correct

b) Detected values (with classic calibration) after step one with assumed (not correct) LO phase and magnitude level; dashed values are correct

Fig. 20

c) Detected values after new method of calibration (step two); dashed and detected values are the same

Fig. 21

<table>
<tr><td colspan="2"><strong>European Patent Office</strong></td><td><strong>EUROPEAN SEARCH REPORT</strong></td><td>Application Number<br>EP 98 10 8835</td></tr>
</table>

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A,D | LI J ET AL: "A SIX-PORT DIRECT DIGITAL MILLIMETER WAVE RECEIVER" IEEE MTT-S INTERNATIONAL MICROWAVE SYMPOSIUM DIGEST, SAN DIEGO, MAY 23 - 27, 1994, vol. VOL. 3, 23 May 1994, pages 1659-1662, XP000512814 KUNO H J;WEN C P (EDITORS) * page 1659, column 1, line 13 - page 161, column 1, line 10; figure 1 * | 1,28 | H03D9/04 H04L27/38 |
| A | JI LI ET AL: "A NEW DIRECT DIGITAL RECEIVER PERFORMING COHERENT PSK RECEPTION" IEEE MTT-S INTERNATIONAL MICROWAVE SYMPOSIUM DIGEST, ORLANDO, MAY 16 - 20, 1995, vol. VOL. 3, 16 May 1995, pages 1007-1010, XP000552909 KIRBY L (ED ) * page 1007, column 1, line 1 - page 1009, column 2, line 2; figure 1 * | 1,28 | |
| A | EP 0 805 561 A (NOKIA MOBILE PHONES LTD) 5 November 1997 * abstract; figures 1,2 * | 1,28 | TECHNICAL FIELDS SEARCHED (Int.Cl.6) H03D H04L G01R H01P H04B |
| A,D | US 4 521 728 A (LI SHIHE) 4 June 1985 | | |
| A,D | US 5 498 969 A (HUYART BERNARD ET AL) 12 March 1996 | | |
| A | US 4 427 936 A (RIBLET GORDON P ET AL) 24 January 1984 | | |

The present search report has been drawn up for all claims

| Place of search | Date of completion of the search | Examiner |
|---|---|---|
| THE HAGUE | 15 September 1998 | Dhondt, I |

EPO FORM 1503 03.82 (P04C01)